# EUROPEAN PATENT APPLICATION

(11) **EP 4 195 898 A1**
(43) Date of publication of application: **14.06.2023**
(21) Application number: 22202370.7
(22) Date of filing: 19.10.2022
(51) Int. Cl.: H10B 12/00

(54) **SEMICONDUCTOR MEMORY DEVICES AND METHODS OF FABRICATING THE SAME**

(30) Priority: 10.12.2021 KR 20210176522
(71) Applicant: Samsung Electronics Co., Ltd., Gyeonggi-do 16677 (KR)
(72) Inventor: PARK, Sohyun, 16677 Suwon-si (KR); KIM, Eunjung, 16677 Suwon-si (KR)
(74) Representative: Marks & Clerk LLP

(57) **Abstract**

A semiconductor memory device may include a substrate (100) including active regions (ACT). Word lines (WL) may be on the active regions (ACT) and may be extended in a first direction (D1). Bit line structures (BS) may be on the word lines (WL), and each of the bit line structures (BS) may include a contact portion (DC), which is connected to a first impurity region (112a) of an active region (ACT), and a line portion (BL), which is on the contact portion (DC) and which extends in a second direction (D2). Contact plugs (BC) may be between the bit line structures (BS) and may be connected to respective second impurity regions (112b) of the active regions (ACT). Connection patterns (193) may connect the contact plugs (BC) to the second impurity regions (112b). Each of the connection patterns (193) may include a first concave surface (SW1) that faces the contact portion (DC) and a second convex surface (SW2) that is opposite to the first surface (SW1).

## Description

### TECHNICAL FIELD

The present disclosure relates to semiconductor devices, and in particular, relates to semiconductor memory devices and to methods of fabricating the same.

### BACKGROUND

Semiconductor devices have achieved recognition as important elements in the electronics industry, due to their small sizes, multifunctionality, and low-cost. However, with the advancement of the electronic industry, there is an increasing demand for semiconductor devices with higher integration density. To increase the integration density of the semiconductor device, it is necessary to reduce line widths of patterns constituting the semiconductor device. However, novel and expensive exposure technologies are increasingly needed to reduce the linewidths of the patterns, and thus, it becomes difficult to increase the integration density of the semiconductor device. Thus, a variety of new technologies are under study in order to overcome various difficulties that arise in increasing integration densities of semiconductor memory devices.

### SUMMARY

Some embodiments of the inventive concepts provide a method of simplifying a process of fabricating a semiconductor memory device and reducing a process variation and a semiconductor memory device fabricated thereby.

According to some embodiments of the inventive concepts, a semiconductor memory device includes a substrate including active regions defined by a device isolation layer, each active region including a first impurity region and a second impurity region, Word lines are on the active regions and extend in a first direction, and bit line structures are on the word lines. Each of the bit line structures includes a contact portion, which is connected to a first impurity region of the active regions, and a line portion, which is on the contact portion and which extends in a second direction that crosses the first direction. Contact plugs are between the bit line structures and connected to respective second impurity regions, and connection patterns connect the contact plugs to the second impurity regions of the active regions. Each of the connection patterns includes a first surface facing the contact portion and a second surface opposite to the first surface. When viewed in a plan view, the first surface is concave in the first direction and the second surface is convex in the first direction.

According to some embodiments of the inventive concepts, a semiconductor memory device may include a substrate including active regions defined by a device isolation layer, with each active region including a first impurity region and a second impurity region. Word lines may be on the active regions and may extend in a first direction, and bit line structures may be on the word lines. Each of the bit line structures may include a contact portion, which is connected to the first impurity region, and a line portion, which is on the contact portion and which extends in a second direction that crosses the first direction. Contact plugs may be between the bit line structures and connected to respective second impurity regions, a connection pattern may connect one of the contact plugs to the respective second impurity region, and a separation insulating pattern may be below the line portion. The connection patterns may include a first concave surface and a second convex surface opposite to the first surface.

According to some embodiments of the inventive concepts, a semiconductor memory device may include a substrate including active regions defined by a device isolation layer, each active region including a first impurity region and a second impurity region. Word lines may be on the active regions and extended in a first direction, a gate dielectric layer may be between the word lines and the active regions, and bit line structures may be on the word lines. Each of the bit line structures may include a contact portion, which is connected to a first impurity region of the active regions, and a line portion, which is on the contact portion and is extended in a second direction crossing the first direction. Contact plugs may be between the bit line structures and connected to respective second impurity regions. Connection patterns may connect the contact plugs to the second impurity regions of the active regions, landing pads may be on the contact plugs, a gapfill structure may at least partially fill a region between the landing pads, and a capacitor may be connected to the second impurity regions through the contact plugs and the landing pads. Each of the connection patterns may include a first concave surface that faces the contact portion and a second convex surface that is opposite to the first surface. A center width in the first direction of each of the connection patterns at a center region thereof may be less than an edge width in the first direction of the connection pattern at an edge portion thereof.

According to some embodiments of the inventive concepts, a method of fabricating a semiconductor memory device includes forming a device isolation layer in a substrate to define active regions, each active region including first impurity regions and second impurity regions; forming word lines in the substrate that extend in a first direction; forming connection lines between the word lines that extend in the first direction; forming sacrificial patterns on respective first impurity region; forming a molding spacer on side surfaces of the sacrificial patterns; patterning the connection lines, which are exposed by the molding spacer, to form preliminary connection patterns spaced apart from each other in the first direction; removing the sacrificial patterns; etching portions of the preliminary connection patterns below the sacrificial patterns to form connection patterns from the preliminary connection patterns; forming bit line structures extending in a second direction that crosses the first direction, the bit line structures connected to the first impurity regions; and forming contact plugs, which are connected to the connection patterns, between the bit line structures.

At least some of the above and other features of the invention are set out in the claims.

### BRIEF DESCRIPTION OF THE DRAWINGS

FIG. 1 is a plan view illustrating a semiconductor memory device according to some embodiments of the inventive concepts.
FIG. 2 is a sectional view taken along lines A1-A2 and B1-B2 of FIG. 1.
FIG. 3 is a sectional view taken along a line C1-C2 of FIG. 1.
FIG. 4 is an enlarged plan view illustrating a portion Q of FIG. 1.
FIGS. 5, 8, 11, 14, 17, 20, 23, 26, and 29 are plan views illustrating a method of fabricating a semiconductor memory device according to some embodiments of the inventive concepts.
FIGS. 6, 9, 12, 15, 18, 21, 24, 27, and 30 are sectional views, which are taken along lines A1-A2 and B1-B2 of FIGS. 5, 8, 11, 14, 17, 20, 23, 26, and 29, respectively.
FIGS. 7, 10, 13, 16, 19, 22, 25, 28, and 31 are sectional views, which are taken along lines C1-C2 of FIGS. 5, 8, 11, 14, 17, 20, 23, 26, and 29, respectively.

### DETAILED DESCRIPTION

Some examples of embodiments of the inventive concepts will now be described more fully with reference to the accompanying drawings, in which aspects of example embodiments are shown.

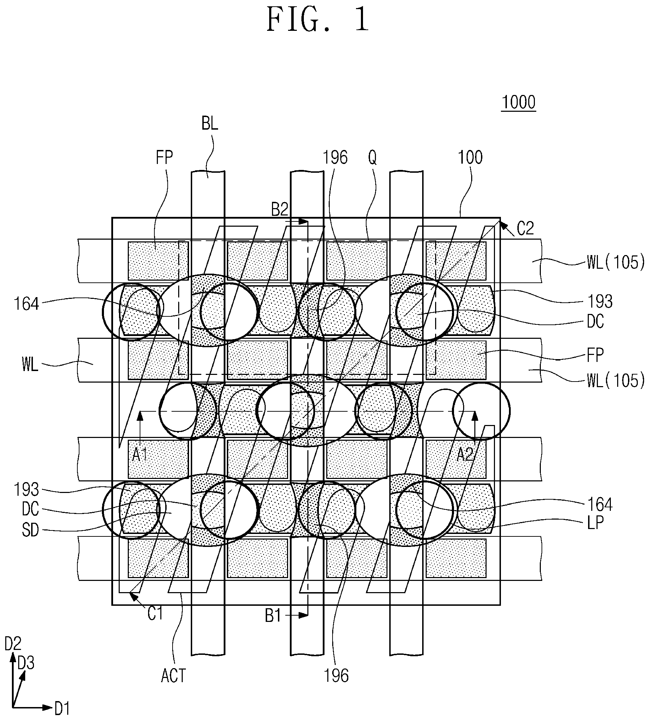

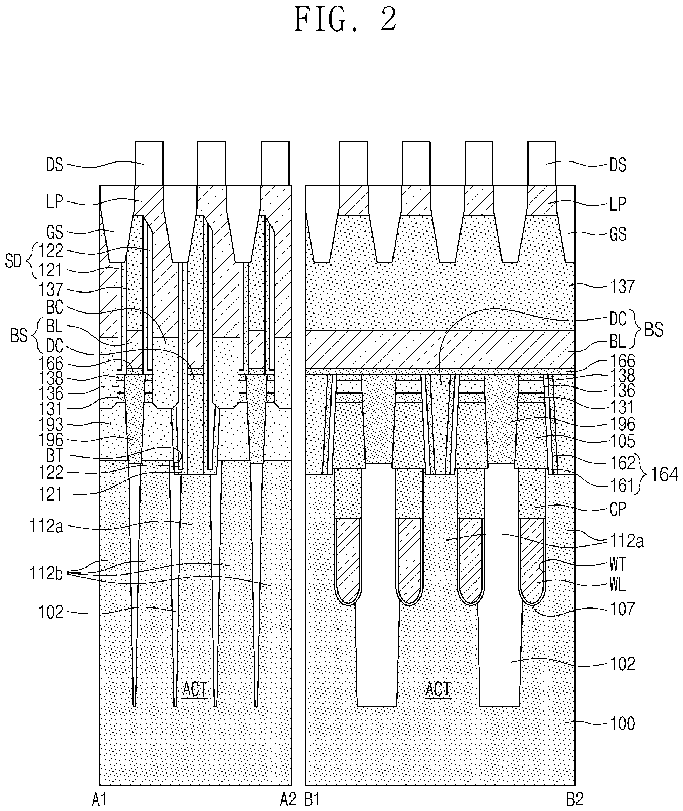

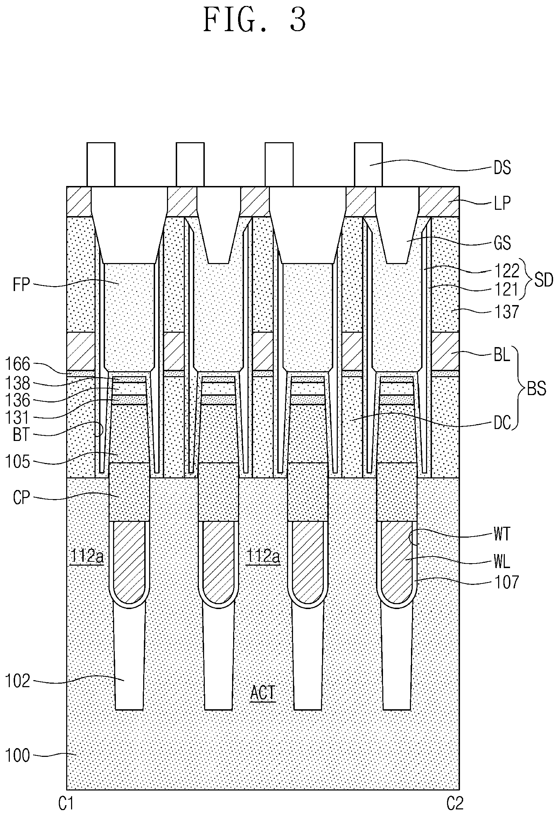

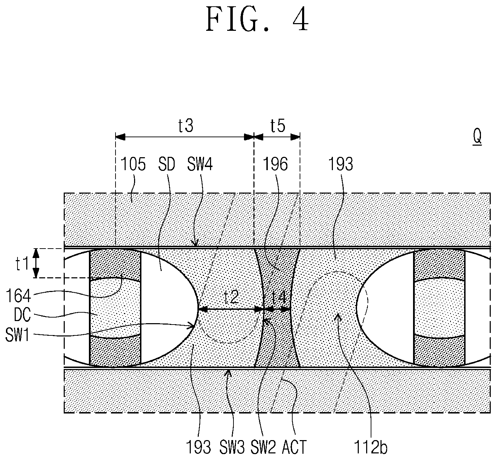

FIG. 1 is a plan view illustrating a semiconductor memory device 1000 according to some embodiments of the inventive concepts. FIG. 2 is a sectional view taken along lines A1-A2 and B1-B2 of FIG. 1. FIG. 3 is a sectional view taken along a line C1-C2 of FIG. 1. FIG. 4 is an enlarged plan view illustrating a portion Q of FIG. 1.

Referring to FIGS. 1 to 4, a device isolation pattern 102 may be arranged in a substrate 100 so as to define active portions ACT. The substrate 100 may be a semiconductor substrate, such as a single-crystalline silicon substrate. Each of the active portions ACT may be isolated from others and may have an island shape. Each of the active portions ACT may be a bar-shaped portion extended in a third direction D3. When viewed in a plan view, the active portions ACT may be portions of the substrate 100 surrounded by the device isolation pattern 102. The active portions ACT may be arranged in the third direction D3 to be parallel to each other, and each of the active portions ACT may be arranged such that an end portion thereof is located relatively near a center of another of the active portions ACT adjacent thereto.

Word lines WL may be provided to cross the active portions ACT. The word lines WL may be in respective first trenches WT, and the first trenches WT may be formed in the device isolation pattern 102 and the active portions ACT. The word lines WL may be parallel to a first direction D1 that crosses the third direction D3. The word lines WL may be formed of or include at least one conductive material. A gate dielectric layer 107 may be between the word line WL and an inner surface of the first trench WT. The gate dielectric layer 107 may be formed of or include at least one of silicon oxide, silicon nitride, silicon oxynitride, and/or high-k dielectric materials. In some embodiments, each active portion ACT may be crossed by a pair of the word lines WL.

A first impurity region 112a may be provided in a portion of each of the active portions ACT between the pair of the word lines WL, and a pair of second impurity regions 112b may be provided in opposite edge regions of each of the active portions ACT. The first and second impurity regions 112a and 112b may be, for example, n-type doped regions. The first impurity region 112a may correspond to a common drain region, and the second impurity region 112b may correspond to a source region. Each of the word lines WL and the first and second impurity regions 112a and 112b adjacent thereto may constitute a transistor.

Top surfaces of the word lines WL may be lower than a top surface of the substrate 100. A height of a bottom surface of the word line WL may vary depending on a material of an underlying element. As an example, a height of a portion of the bottom surface of the word line WL, which is provided on the active portion ACT, may be higher than a height of a portion provided on the device isolation pattern 102.

A capping pattern CP may be provided to cover each of the word lines WL and may be extended in the first direction D1. The capping patterns CP may be buried in the substrate 100 and may be respectively provided on the word lines WL. The capping patterns CP may fill upper portions of the first trenches WT The capping patterns CP may be formed of or include at least one of, for example, silicon nitride or silicon oxynitride. In some embodiments, a side surface of the capping pattern CP may be defined by an inner sidewall of the first trench WT and thus may be aligned to a side surface of the gate dielectric layer 107. Alternatively, in some embodiments the gate dielectric layer 107 may be extended along a side surface of the first trench WT to cover at least a portion of the side surface of the capping pattern CP.

Intermediate insulating patterns 105 may be provided on the capping patterns CP and may be provided on the word lines WL, respectively. Each of the intermediate insulating patterns 105 may be extended in the first direction D1. In each of the intermediate insulating patterns 105, a width of a lower portion may be larger than a width of an upper portion. The intermediate insulating patterns 105 may be formed of or include at least one of, for example, silicon nitride or silicon oxynitride. A thickness of the intermediate insulating patterns 105 may be larger than a thickness of the capping patterns CP, when measured in a direction perpendicular to the substrate 100. Stated differently, a portion of an intermediate insulating pattern 105 may have a thickness greater than a portion of a respective capping pattern CP immediately below the intermediate insulating pattern 105.

A buffer insulating layer 131, a first etch stop layer 136, and a second etch stop layer 138 may be sequentially provided on the intermediate insulating patterns 105. As an example, the buffer insulating layer 131 and the second etch stop layer 138 may be a silicon nitride layer, and the first etch stop layer 136 may be a silicon oxide layer. Alternatively, at least one of the buffer insulating layer 131, the first etch stop layer 136, and the second etch stop layer 138 may be omitted. Each of the first and second buffer insulating layers 105 and 131 may have an island-shaped pattern that is isolated from the others, when viewed in a plan view.

Bit line structures BS may be provided on the second etch stop layer 138. Each of the bit line structures BS may be placed on the word lines WL and may be extended in a second direction D2 that crosses the first direction D1. In some embodiments, the first direction D1 may be perpendicular to the second direction D2, and the third direction D3 may be non-perpendicular to the first and second directions D1 and D2. Each of the bit line structures BS may include contact portions DC, which are connected to the first impurity regions 112a, and a line portion BL, which may be extended in the second direction D2 and connected in common to the contact portions DC. When measured in a direction perpendicular to the substrate 100, a thickness of the line portion BL may be smaller than a thickness of the contact portions DC.

The contact portions DC may be formed of or include at least one semiconductor material (e.g., silicon), conductive metal nitride material, and/or metallic material. The line portion BL may be formed of or include at least one metallic material (e.g., tungsten, titanium, or tantalum). The bit line structure BS may include a barrier layer 166 provided between the contact portions DC and the line portions BL, but the present disclosure is not limited to this example. As an example, the barrier layer 166 may be formed of or include at least one conductive metal nitride material (e.g., titanium nitride, tungsten nitride, or tantalum nitride). In the case where the contact portion DC is a metal layer, a metal silicide layer may be provided between the contact portion DC and the first impurity region 112a. The metal silicide layer may be formed of or include at least one of titanium silicide, cobalt silicide, or nickel silicide, as examples. In each of the contact portions DC, an upper width may be larger than a lower width. That is, a planar area of the contact portion DC may decrease in a direction from a top surface thereof toward a bottom surface thereof.

Bit line capping patterns 137 may be respectively on the bit line structures BS to extend in the second direction D2. The bit line capping patterns 137 may be formed of or include an insulating material (e.g., silicon nitride).

Spacers SD may be provided to cover opposite side surfaces of each bit line structure BS. The spacer SD may be extended to cover side surfaces of the bit line capping patterns 137. The spacer SD may be formed of or include at least one of silicon nitride, silicon oxide, or silicon oxynitride. As an example, the spacer SD may include a first spacer layer 121 and a second spacer layer 122. The first spacer layer 121 may be formed of or include silicon nitride, and the second spacer layer 122 may be formed of or include silicon oxide. The spacer SD may further include a third spacer layer containing silicon nitride. In some embodiments, an air gap may be provided in place of the second spacer layer 122.

The spacer SD may be extended along the bit line structure BS or in the second direction D2. The spacers SD may be provided to cover two side surfaces of the contact portion DC, which may be exposed in the first direction D1 and an opposite direction thereof. Referring to FIG. 4, each of the contact portion DC may include opposite side surfaces that are respectively covered with a pair of hemi-spherical spacers SD, when viewed in a plan view. For example, each of the contact portions DC may include first and second side surfaces, which may be exposed in the first direction D1 and the opposite direction thereof, and the spacers SD may be respectively provided on the first and second side surfaces of each contact portion DC. When viewed in a sectional view, as shown in FIGS. 2 and 3, the spacers SD may be provided in fourth trenches BT, which may be formed at both sides of the contact portion DC.

The contact portion DC may include third and fourth side surfaces, each of which connects the first and second side surfaces to each other, and sidewall insulating patterns 164 may be provided on the third and fourth side surfaces, respectively. As shown in the plan view of FIG. 4, each of the sidewall insulating patterns 164 may have a substantially constant thickness t1, when measured along a side surface of the contact portion DC. This is because, in a fabrication process described in greater detail herein, the sidewall insulating patterns 164 are formed by a similar method to the spacer. The sidewall insulating pattern 164 may include a first surface, which may be in contact with the contact portion DC, and a second surface, which is opposite to the first surface. The first surface of the sidewall insulating pattern 164 may be concave in the second direction D2, and the second surface of the sidewall insulating pattern 164 may be convex in the second direction D2.

The sidewall insulating patterns 164 may include a plurality of insulating layers. As an example, the sidewall insulating patterns 164 may include a first insulating pattern 161 and a second insulating pattern 162. The first insulating pattern 161 may be formed of or include silicon oxide, and the second insulating pattern 162 may be formed of or include silicon nitride. Alternatively, the first insulating pattern 161 may be a single insulating layer or may include three or more insulating layers.

As shown in FIG. 4, the contact portion DC may be surrounded by a pair of the sidewall insulating patterns 164 and a pair of the spacers SD. Stated differently, in a plan view, each contact portion DC may be enclosed by a pair of spacers SD (provided on the first and second side surfaces of the contact portion DC) and by a pair of sidewall insulating patterns 164 (provided on the third and fourth side surfaces of the contact portion DC). A structure, which may be composed of the contact portion DC, the pair of the sidewall insulating patterns 164, and the pair of the spacers SD, may have an elliptical and/or circular shape, when viewed in a plan view.

Contact plugs BC may be between an adjacent pair of the bit line structures BS. The contact plugs BC may be formed of or include at least one of doped or undoped polysilicon or metallic materials. The contact plugs BC may be two-dimensionally spaced apart from each other. Although they are not illustrated as such for the sake of brevity, in some embodiments the contact plugs BC may be respectively provided on connection patterns 193 to be described in greater detail herein.

The connection patterns 193 may be respectively provided between the contact plugs BC and the second impurity regions 112b. The connection patterns 193 may be respectively on the second impurity regions 112b and may be two-dimensionally spaced apart from each other. The connection patterns 193, which are arranged in the first direction D1, may be spaced apart from each other with the bit line structures BS interposed therebetween. The connection patterns 193, which are arranged in the second direction D2, may be spaced apart from each other with the intermediate insulating patterns 105 interposed therebetween. The connection patterns 193 may be formed of or include at least one semiconductor material. As an example, the connection patterns 193 may be formed of or include at least one of doped or undoped poly silicon or metallic material.

Each of the connection patterns 193 may be at the same level as the contact portion DC. Bottom surfaces of the connection patterns 193 may be higher than bottom surfaces of the contact portions DC, and top surfaces of the connection patterns 193 may be lower than top surfaces of the contact portions DC. The connection patterns 193 may be between the intermediate insulating patterns 105.

Hereinafter, the connection patterns 193 and elements adjacent thereto will be described in greater detail with reference to FIGS. 1 and 4. A pair of the connection patterns 193 may be between a pair of the contact portions DC. Each of the pair of the connection patterns 193 may be spaced apart from the contact portions DC, which are adjacent thereto, with the spacer SD interposed therebetween. The pair of the connection patterns 193 may be spaced apart from each other by a separation insulating pattern 196 interposed therebetween. The pair of the connection patterns 193 may be provided to have a mirror symmetry about the separation insulating pattern 196.

Each of the connection patterns 193 may include a first surface SW1, which faces the contact portion DC and the spacer SD adjacent thereto, and a second surface SW2, which is opposite to the first surface SW1 and faces the separation insulating pattern 196. Each of the connection patterns 193 may further include a third surface SW3 and a fourth surface SW4, each of which connects the first surface SW1 to the second surface SW2. The spacer SD may be extended into a region between the first surface SW1 and the contact portion DC. The first surface SW1 may be in contact with the spacer SD. The second surface SW2 may be in contact with the separation insulating pattern 196. The third and fourth surfaces SW3 and SW4 may be in contact with respective intermediate insulating patterns 105.

Herein, in the interest of brevity, the following description will refer to the connection pattern 193 placed at the left side of the separation insulating pattern 196 in FIG. 4, but the connection pattern 193 placed at the right side of the separation insulating pattern 196 may have the same or similar features. The first surface SW1 of the connection pattern 193 may be concave in the first direction D1, and the second surface SW2 of the connection pattern 193 may be convex in the first direction D1. A curvature radius of the second surface SW2 of the connection pattern 193 may be larger than a curvature radius of the first surface SW1 of the connection pattern 193. The third and fourth surfaces SW3 and SW4 of the connection pattern 193 may have a line shape.

A width of the connection pattern 193 in the first direction D1 may vary depending on position. As an example, a second width t2 (or center width) of a center portion of the connection pattern 193 in the first direction D1 may be smaller than a third width t3 (or edge width) of edge portions of the connection pattern 193 in the first direction D1. In the connection pattern 193, the center portion may be defined as a portion that is equidistant from the pair of the intermediate insulating patterns 105, and the edge portions may be defined as portions adjacent to the third and fourth surfaces SW3 and SW4. The third width t3 may be 1.1 to 2.0 times the second width t2. The connection pattern 193 may have the smallest width at the center portion and the largest width at the edge portions, when measured in the first direction D1.

As discussed above, the separation insulating pattern 196 may be in contact with the pair of the connection patterns 193. In other words, a first surface of the separation insulating pattern 196 may be in contact with the second surface SW2 of one of the pair of the connection patterns 193, and a second surface of the separation insulating pattern 196 may be in contact with the second surface SW2 of the other of the pair of the connection patterns 193. The separation insulating pattern 196 may include a third surface and a fourth surface, which connect the first and second surfaces to each other and are in contact with the intermediate insulating patterns 105, respectively. The second surface SW2 of the connection patterns 193 may be convex toward the separation insulating pattern 196 in contact therewith.

Since the second surfaces SW2 of the pair of the connection patterns 193 protrudes toward the separation insulating pattern 196, a fourth width t4 of a center portion of the separation insulating pattern 196 in the first direction D1 may be smaller than a fifth width t5 of edge portions thereof in the first direction D1. The fifth width t5 may be 1.2 to 3.0 times the fourth width t4. As an example, the separation insulating pattern 196 may have a shape resembling a concave lens. The center portion of the separation insulating pattern 196 may be defined as a portion that is equidistant from the pair of the intermediate insulating patterns 105, and the edge portions may be defined as portions that are adjacent to the third and fourth surfaces of the separation insulating pattern 196. The separation insulating pattern 196 may be formed of or include at least one of silicon nitride or silicon oxynitride.

Referring back to FIGS. 1 to 3, fence patterns FP may at least partially fill regions between the bit line structures BS. The fence patterns FP may be spaced apart from each other in the first direction D1, as shown in FIG. 1, but in some embodiments, they may be line-shaped patterns which are extended along the word lines WL or in the first direction D1. Side surfaces of the fence patterns FP, in conjunction with side surfaces of the bit line structures BS, may define spaces, in which the contact plugs BC are provided. The fence patterns FP may be formed of or include at least one of silicon nitride or silicon oxynitride.

Landing pads LP may be on the contact plugs BC, respectively. The landing pads LP may be formed of or include a metal-containing material (e.g., tungsten). Each of the landing pads LP may be electrically connected to a corresponding one of the contact plugs BC. An upper portion of the landing pad LP may cover a top surface of the bit line capping pattern 137 and may have a width larger than the contact plug BC. A center of the landing pad LP may be shifted from a center of the contact plug BC in the first direction D1 or the opposite direction thereof, as shown in FIG. 1. Portions of each of the line portions BL may be vertically overlapped with the landing pads LP. An ohmic layer may be provided between the contact plugs BC and the landing pads LP. The ohmic layer may be a metal silicide layer.

A gapfill structure GS may at least partially fill a region between the landing pads LP. The gapfill structure GS may be provided in a recess region that is defined by side surfaces of the landing pads LP and side surfaces of the bit line capping patterns 137. When viewed in a plan view, the gapfill structure GS may have a shape that at least partially fills a space between the landing pads LP, which are two-dimensionally spaced apart from each other. As an example, a planar shape of the gapfill structure GS may be a mesh shape including holes which are pierced by the landing pads LP. The gapfill structure GS may be formed of or include silicon oxide.

A data storage DS may be provided on each of the landing pads LP. In the case where the semiconductor memory device is a DRAM device, the data storage DS may include a capacitor. As an example, the data storage DS may include bottom electrodes, a top electrode, and a dielectric layer.

According to some embodiments of the inventive concepts, it may be possible to form connection patterns aligned to a side surface of a contact portion (in particular, a side surface of a spacer). The connection patterns may be between the spacer and a separation insulating pattern.

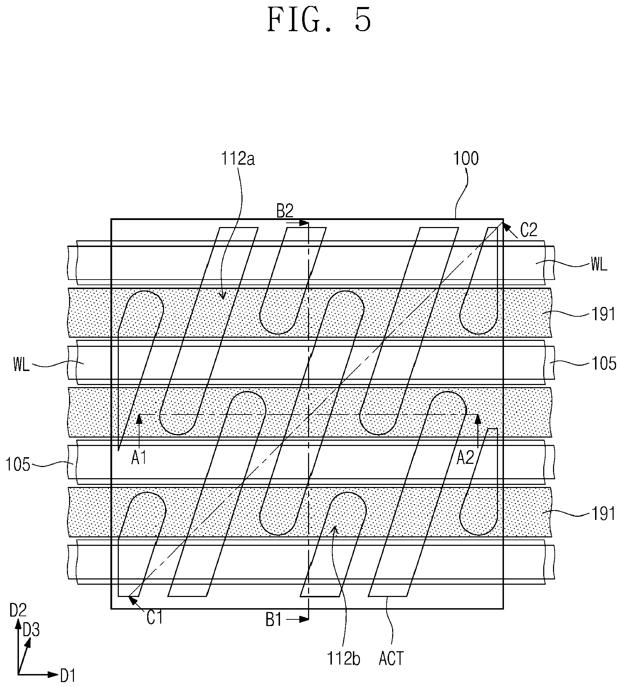

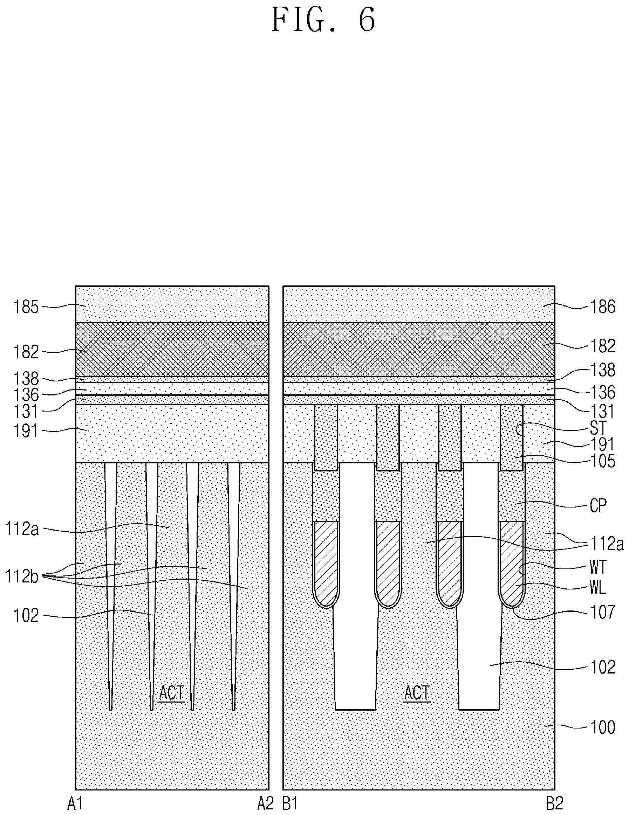

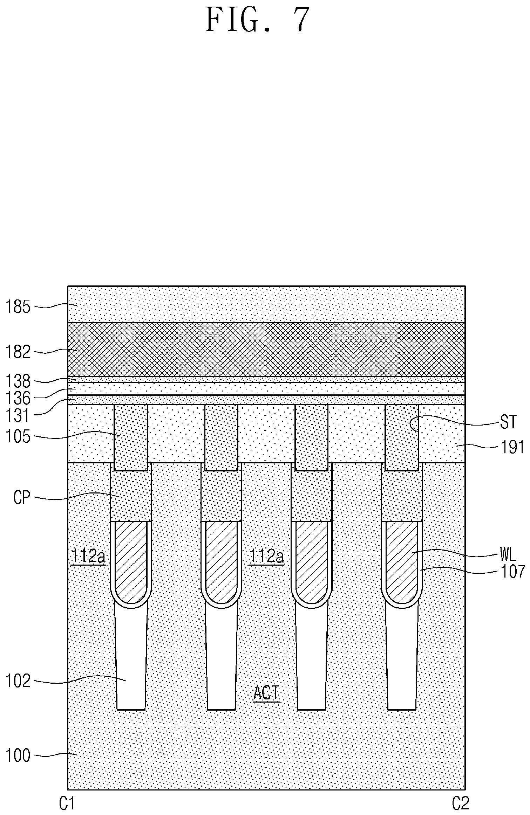

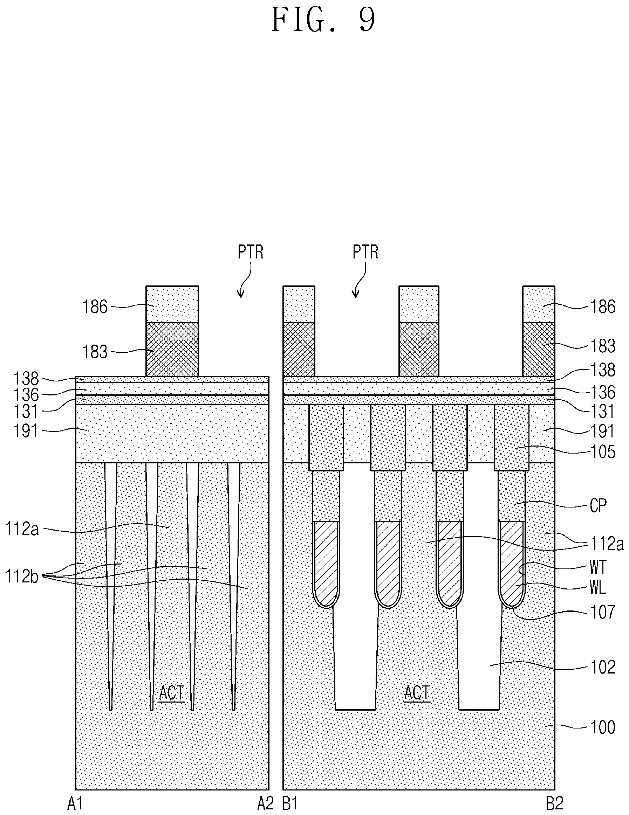

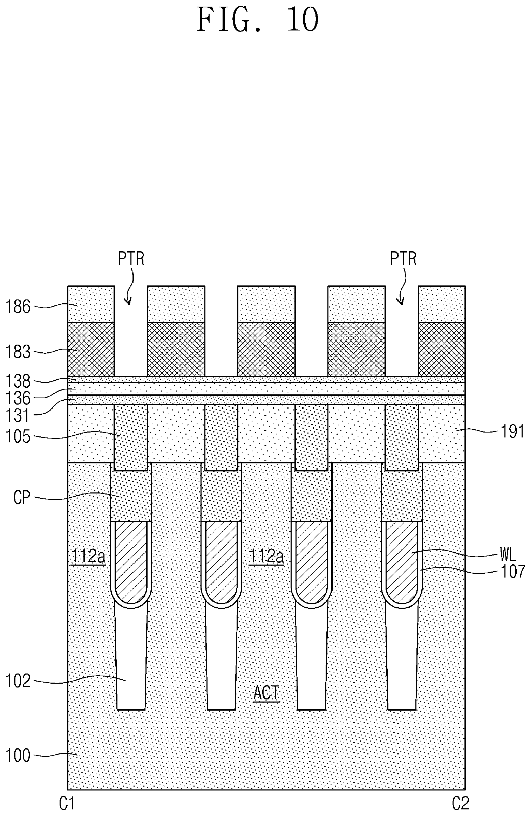

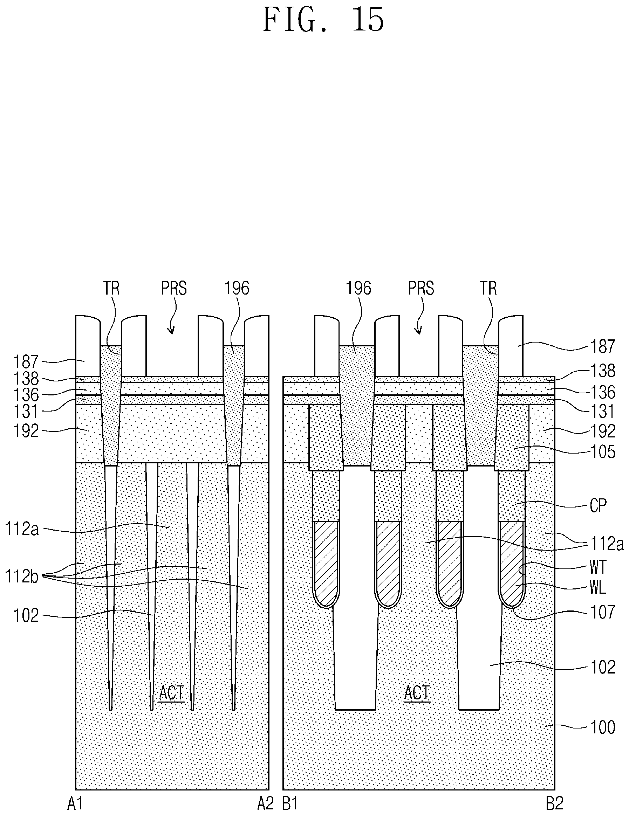

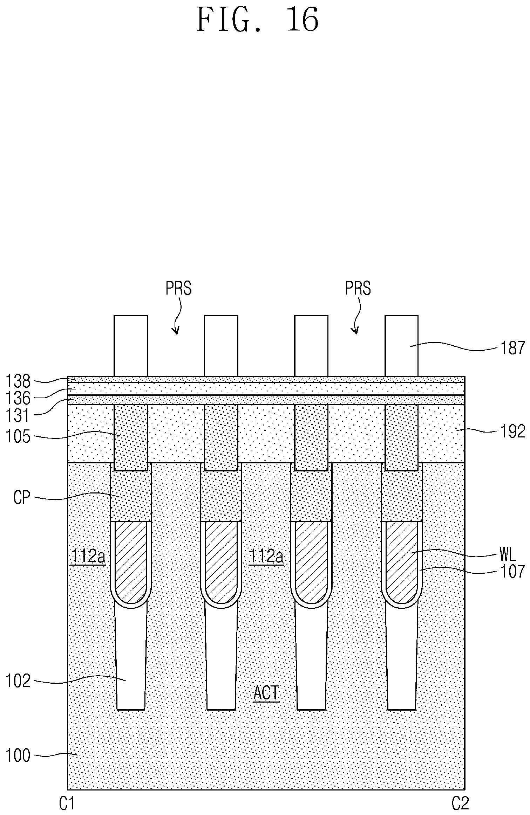

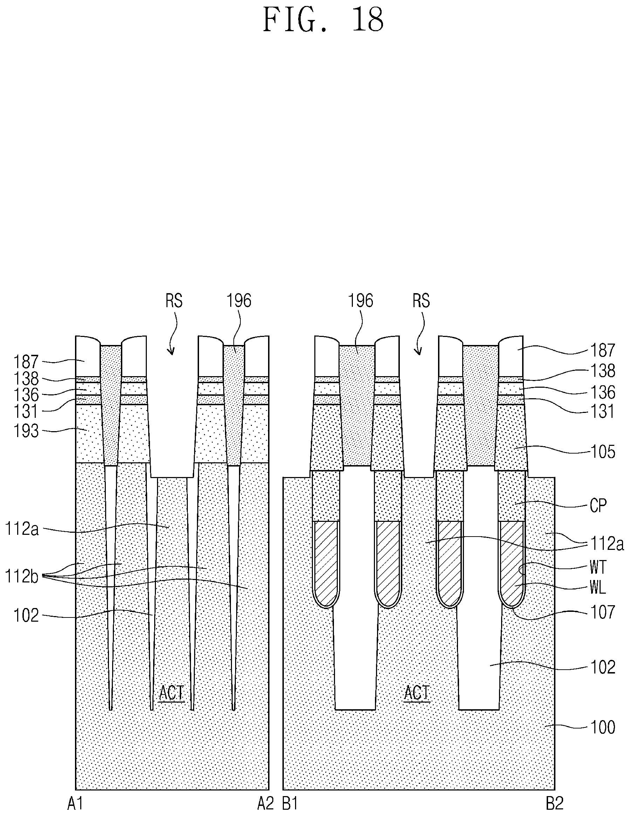

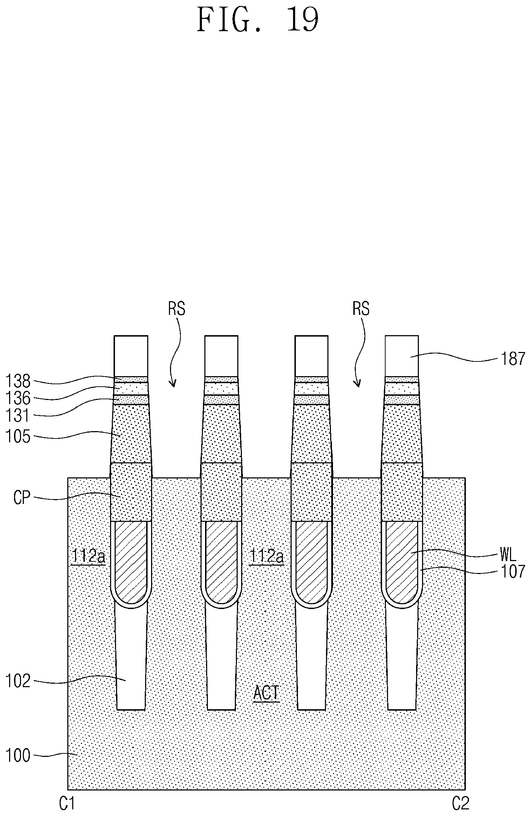

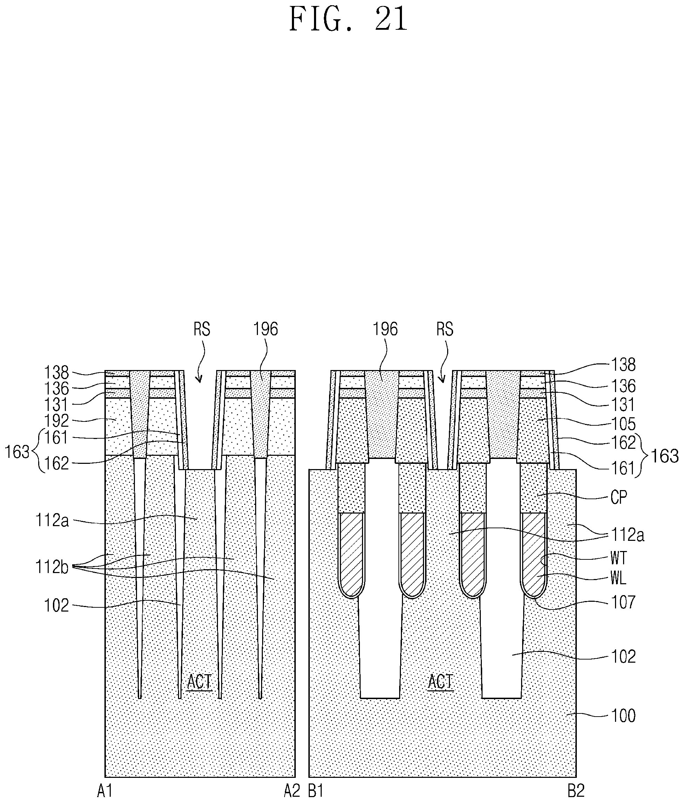

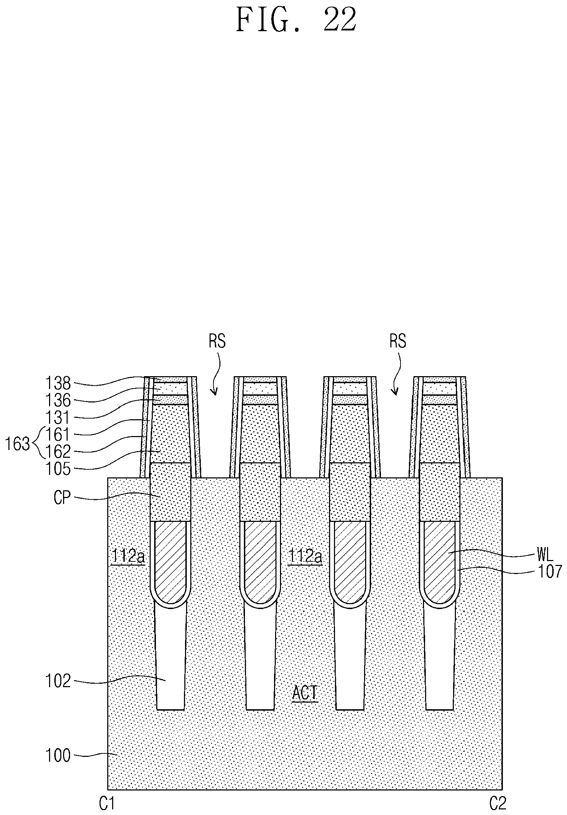

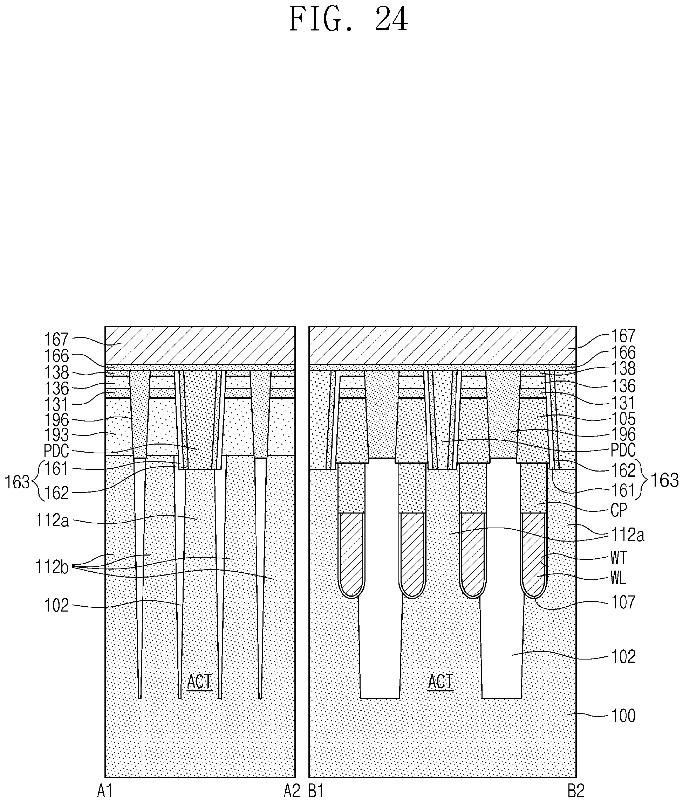

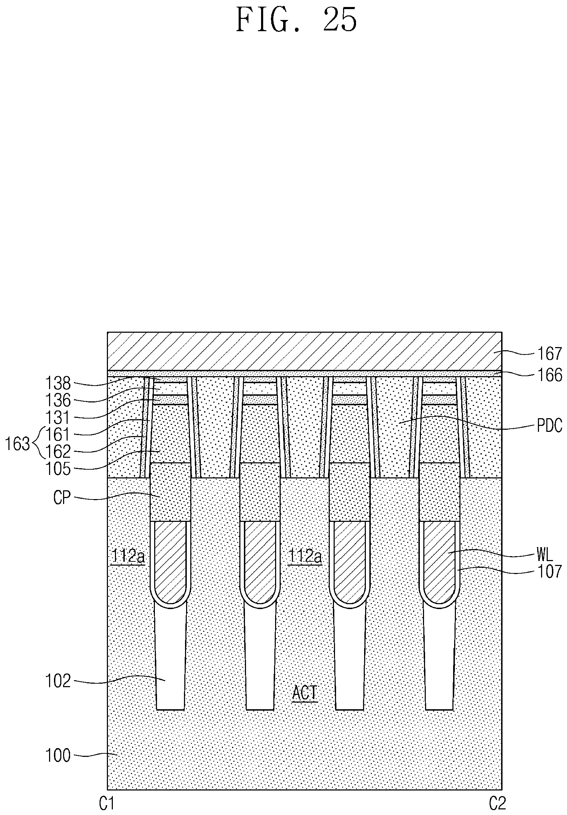

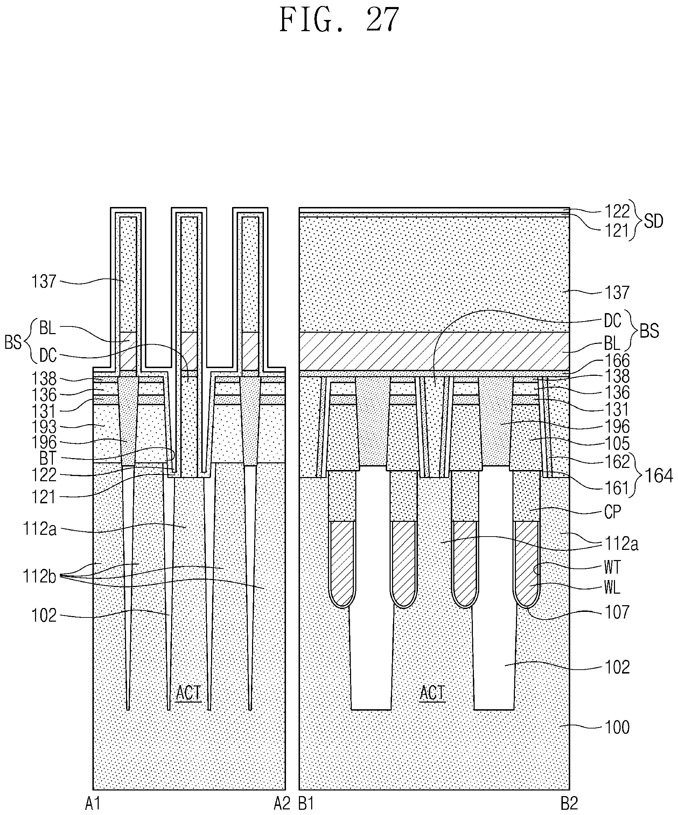

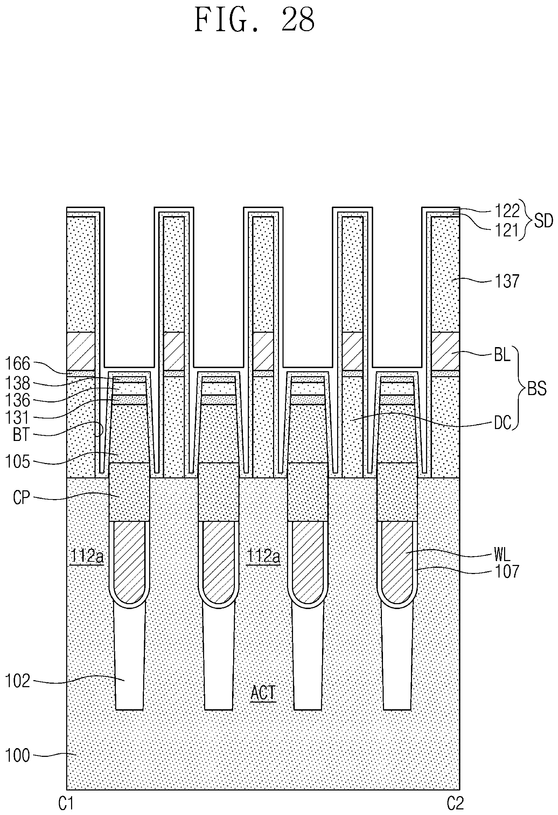

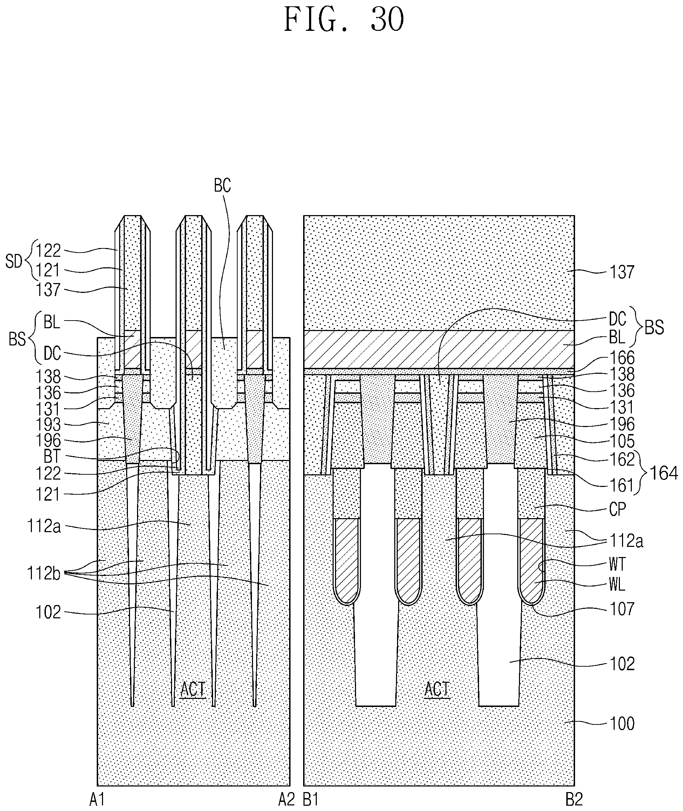

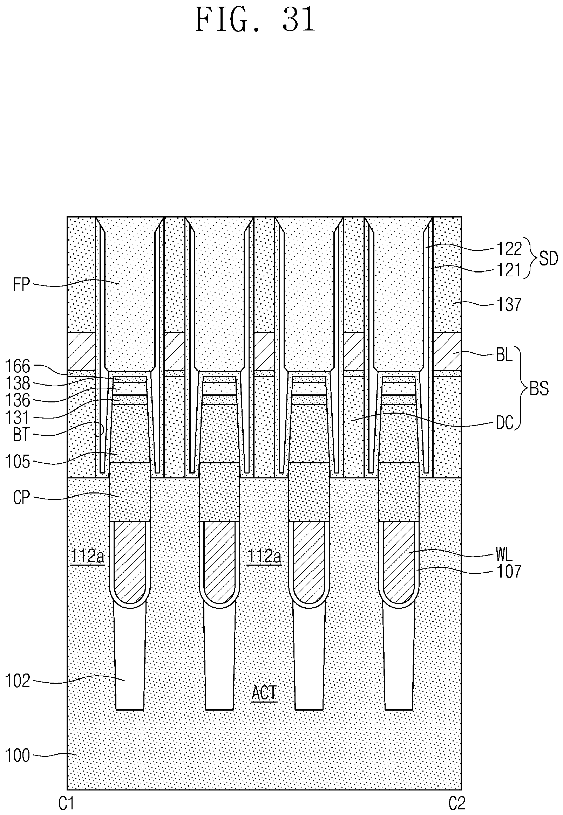

FIGS. 5, 8, 11, 14, 17, 20, 23, 26, and 29 are plan views illustrating a method of fabricating a semiconductor memory device according to an embodiment of the inventive concept. FIGS. 6, 9, 12, 15, 18, 21, 24, 27, and 30 are sectional views, which are taken along lines A1-A2 and B1-B2 of FIGS. 5, 8, 11, 14, 17, 20, 23, 26, and 29, respectively. FIGS. 7, 10, 13, 16, 19, 22, 25, 28, and 31 are sectional views, which are taken along lines C1-C2 of FIGS. 5, 8, 11, 14, 17, 20, 23, 26, and 29, respectively.

Referring to FIGS. 5 to 7, the device isolation pattern 102 may be formed in the substrate 100 to define the active portions ACT. As an example, grooves may be formed in the substrate 100, and the device isolation pattern 102 may be formed by filling the grooves with an insulating material. A depth of the device isolation pattern 102 may vary depending on a distance between the active portions ACT. As an example, the device isolation pattern 102 may be formed of or include silicon oxide.

Impurities may be injected into the active portions ACT. Accordingly, the first and second impurity regions 112a and 112b may be formed in the active portions ACT. The first and second impurity regions 112a and 112b may have a conductivity type different from the substrate 100. As an example, in the case where the substrate 100 has a p-type conductivity, each of the first and second impurity regions 112a and 112b may have an n-type conductivity.

The first trenches WT may be formed in an upper portion of the substrate 100. The formation of the first trenches WT may include forming mask patterns and performing an anisotropic etching process using the mask patterns. Each of the first trenches WT may be extended in the first direction D1. The word lines WL may be formed in respective first trenches WT. A pair of the word lines WL may be formed to cross each of the active portions ACT. Before the formation of the word lines WL, the gate dielectric layer 107 may be formed on an inner surface of each of the first trenches WT The gate dielectric layer 107 may be formed by a thermal oxidation process, a chemical vapor deposition process, and/or an atomic layer deposition process. A conductive layer may be formed on the substrate 100 to fill the first trenches WT, and an etch-back or chemical-mechanical polishing process may be performed to form the word lines WL in the first trenches WT. The word lines WL may be recessed to have top surfaces that are lower than top surfaces of the active portions ACT.

The capping patterns CP may be formed to fill portions of the first trenches WT The capping patterns CP may be in contact with the top surfaces of the word lines WL. The capping patterns CP may be formed of or include at least one of silicon nitride or silicon oxynitride. The formation of the capping patterns CP may include forming an insulating layer to fill the first trenches WT and performing a planarization process to expose the top surface of the substrate 100.

A connection layer may be formed to cover the top surface of the substrate 100, and then, connection lines 191 may be formed by forming second trenches ST penetrating the connection layer. The connection lines 191 may be formed of a semiconductor material. In some embodiments, the connection lines 191 may be formed of or include doped or undoped poly silicon. The connection lines 191 may be formed by a chemical vapor deposition process or an atomic layer deposition process. The second trenches ST may be extended in the first direction D1, and thus, the connection lines 191 may be spaced apart from each other in the second direction D2. The second trenches ST may be formed to expose top surfaces of the capping patterns CP.

The intermediate insulating patterns 105 may be formed to fill the second trenches ST. The intermediate insulating patterns 105 may be formed by forming a silicon nitride layer or a silicon oxynitride layer to fill the second trenches ST and performing a planarization process. The intermediate insulating patterns 105 may be in contact with the top surfaces of the capping patterns CP and may be extended along the capping patterns CP or in the first direction D1.

The buffer insulating layer 131, the first etch stop layer 136, and the second etch stop layer 138 may be sequentially formed on the connection lines 191. As an example, the buffer insulating layer 131 and the second etch stop layer 138 may be formed of or include silicon nitride, and the first etch stop layer 136 may be formed of or include silicon oxide. A sacrificial insulating layer 182 and a mask layer 185 may be sequentially formed on the second etch stop layer 138. The sacrificial insulating layer 182 may be formed of or include a material that has an etch selectivity with respect to silicon oxide and silicon nitride. As an example, the sacrificial insulating layer 182 may include an amorphous carbon layer. The mask layer 185 may be formed of or include at least one of silicon nitride or silicon oxynitride.

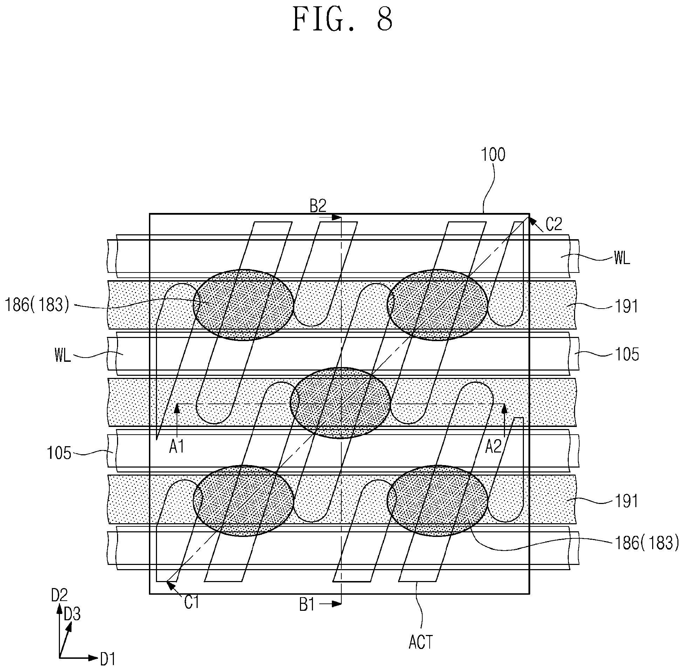

Referring to FIGS. 8 to 10, mask patterns 186 may be formed from the mask layer 185, and sacrificial patterns 183 may be formed from the sacrificial insulating layer 182 through an etching process using the mask patterns 186. The formation of the mask patterns 186 may include performing an etching process using a photoresist layer. The sacrificial patterns 183 may have an elliptical shape as shown in FIG. 8, but in some embodiments, the sacrificial patterns 183 may have a circular or polygonal shape. A preliminary recess region PTR may be formed between the sacrificial patterns 183. A bottom surface of the preliminary recess region PTR may be defined by the second etch stop layer 138.

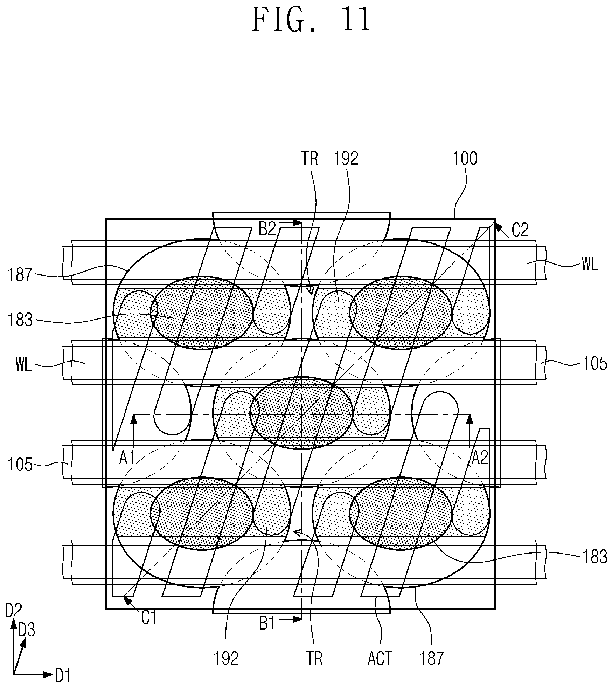

Referring to FIGS. 11 to 13, a molding spacer 187 may be formed to cover side surfaces of the sacrificial patterns 183 and side surfaces of the mask patterns 186, and an etching process using the mask patterns 186 and the molding spacer 187 may be performed to expand the preliminary recess region PTR and thereby to form recess regions TR. The molding spacer 187 may be formed of or include at least one of silicon nitride or silicon oxynitride.

The formation of the molding spacer 187 may include forming a spacer layer to cover side surfaces of the sacrificial patterns 183 and the mask patterns 186 and performing an anisotropic etching process on the spacer layer. When viewed in a plan view, the molding spacer 187 may have a shape, in which a plurality of ellipses are connected. In more detail, as shown in FIG. 11, the molding spacer 187 may have a shape, in which one ellipse is connected to four other ellipses. The recess regions TR may be regions that are exposed by the four ellipses. The recess regions TR may be between four sacrificial patterns 183, which are adjacent to each other.

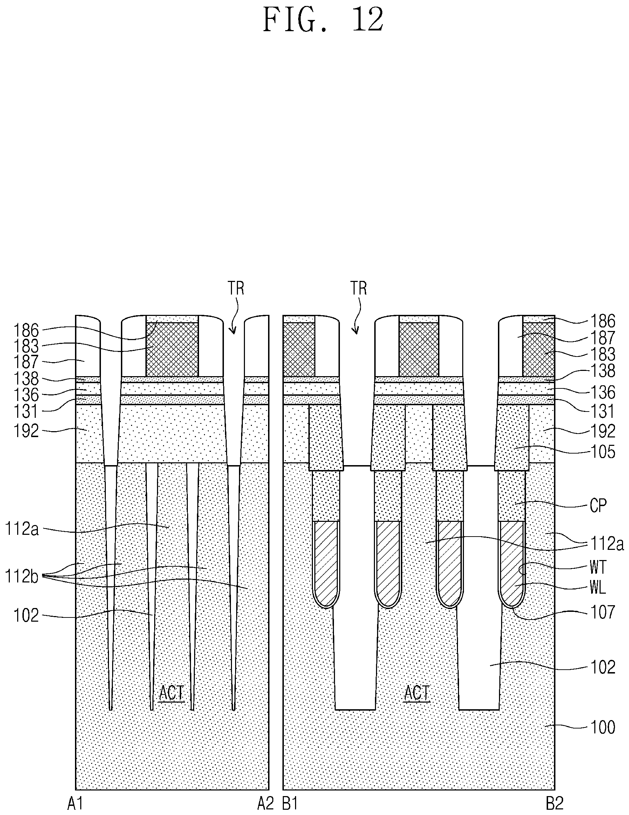

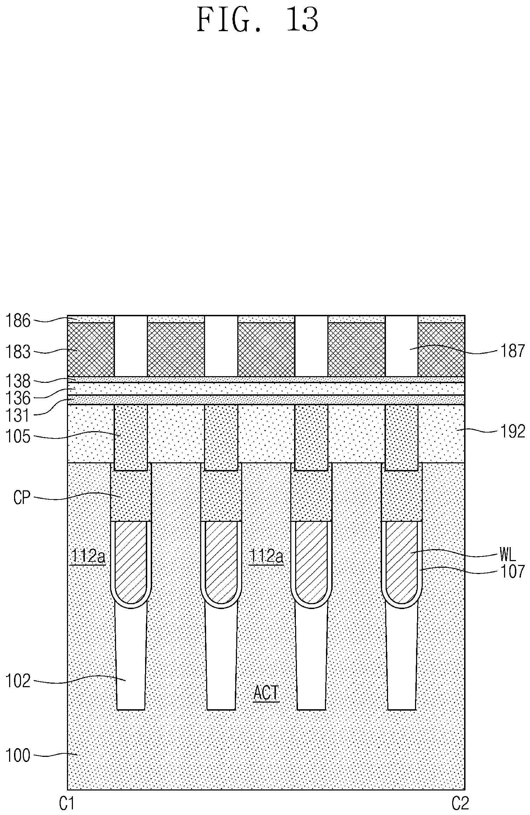

The recess regions TR may be formed to penetrate the second etch stop layer 138, the first etch stop layer 136, the buffer insulating layer 131, and the connection lines 191 and to expose a top surface of the device isolation pattern 102. As a result, each of the connection lines 191 extending in the first direction D1 may be divided into preliminary connection patterns 192, which are separated from each other in the first direction D1. In other words, the connection line 191 below a pair of the sacrificial patterns 183, which are adjacent to each other in the first direction D1, may be separated from each other between the pair of the sacrificial patterns 183. After the formation of the recess regions TR, the mask patterns 186 may be removed but may be partially left as shown in FIGS. 12 and 13.

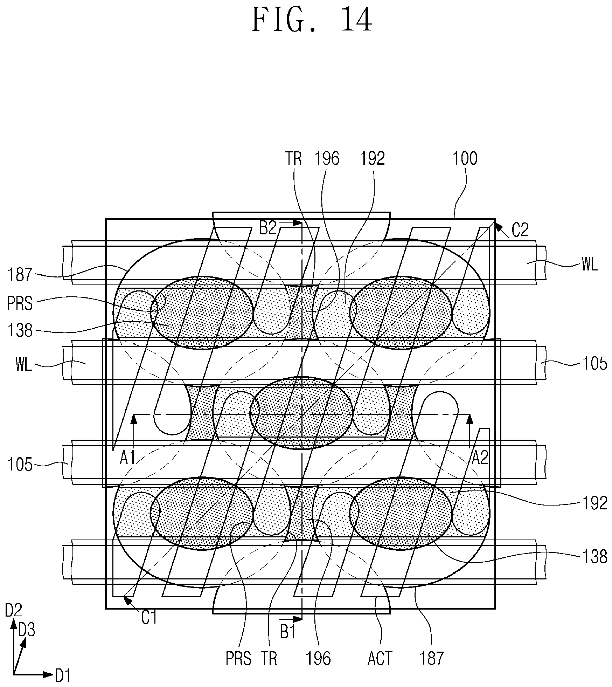

Referring to FIGS. 14 to 16, the separation insulating patterns 196 may be formed to fill the recess regions TR. The separation insulating patterns 196 may be formed by forming an insulating layer to cover the recess regions TR and performing an etch-back process on the insulating layer. The separation insulating patterns 196 may be formed of or include at least one of silicon nitride or silicon oxynitride.

The sacrificial patterns 183 may be selectively removed to form preliminary third trenches PRS exposing the second etch stop layer 138. Each of the preliminary third trenches PRS may have an elliptical shape, when viewed in a plan view. The sacrificial patterns 183 may be formed of or include a material that has an etch selectivity with respect to silicon oxide and silicon nitride. As an example, the sacrificial patterns 183 may include an amorphous carbon layer. In this case, it may be possible to reduce loss of the separation insulating patterns 196 and the molding spacer 187, when the sacrificial patterns 183 are removed.

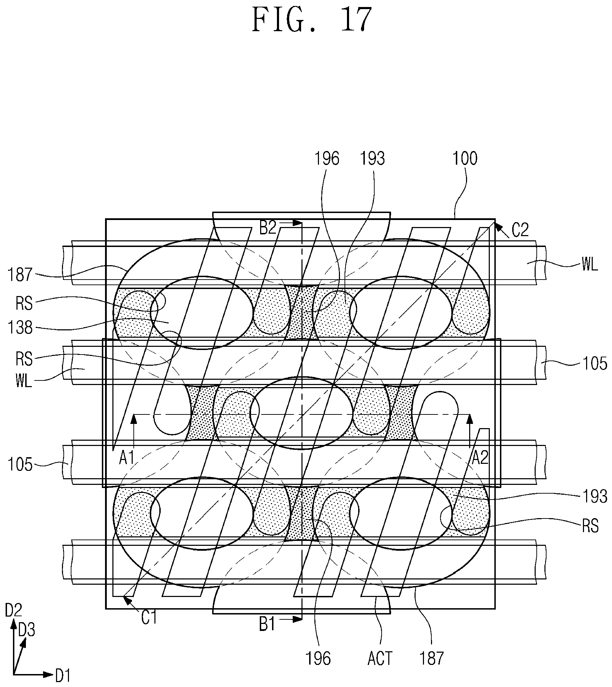

Referring to FIGS. 17 to 19, third trenches RS may be formed by expanding the preliminary third trenches PRS through an anisotropic etching process using the molding spacer 187 and the separation insulating patterns 196 as a mask. The third trenches RS may be formed to penetrate the preliminary connection patterns 192, respectively, and to expose upper portions of the substrate 100. As a result, each of the preliminary connection patterns 192 may be divided into a pair of the connection patterns 193, which are separated from each other by the third trench RS interposed therebetween.

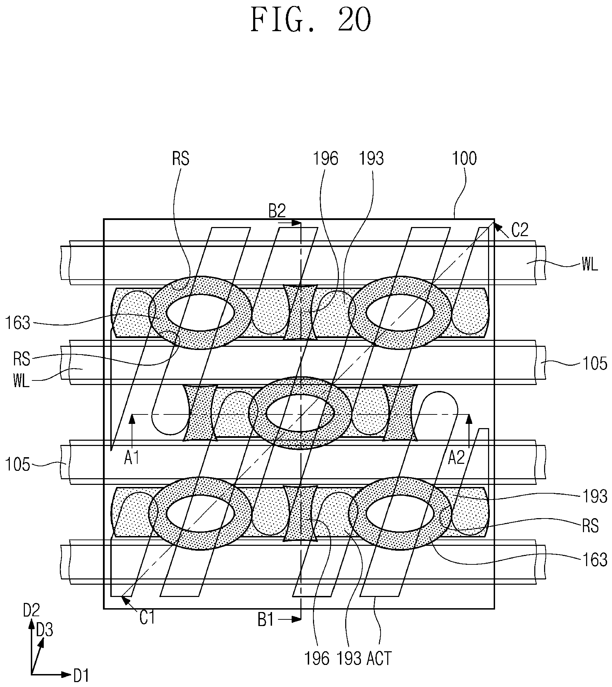

Referring to FIGS. 20 to 22, preliminary sidewall insulating patterns 163 may be formed to cover inner sidewalls of the third trenches RS. The preliminary sidewall insulating patterns 163 may include the first insulating pattern 161 and the second insulating pattern 162. The first insulating pattern 161 may be formed of or include silicon oxide, and the second insulating pattern 162 may be formed of or include silicon nitride. The preliminary sidewall insulating patterns 163 may be formed by forming an insulating layer to cover the third trenches RS and performing an etch-back process on the insulating layer. In some embodiments, upper portions of the separation insulating patterns 196 may be removed during the etch-back process.

Before or after the etch-back process, the molding spacer 187 may be removed by performing an ashing process. After the formation of the preliminary sidewall insulating patterns 163, p-type impurities may be injected into the active portions ACT of the substrate 100 exposed by the third trenches RS. In other words, an additional impurity injection process may be performed on the first impurity regions 112a. However, in some embodiments, the impurity injection process may be omitted.

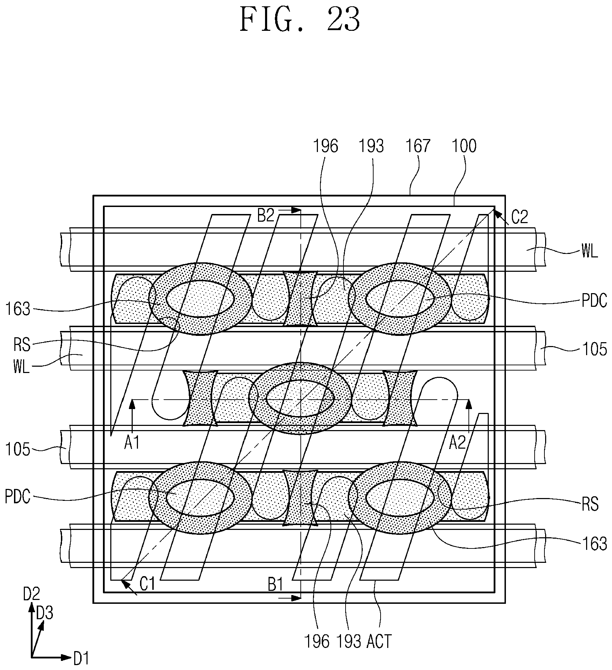

Referring to FIGS. 23 to 25, preliminary contact portions PDC may be formed to fill the third trenches RS. The preliminary contact portions PDC may be electrically and/or physically connected to the first impurity regions 112a. When viewed in a plan view, the preliminary contact portions PDC may have an elliptical shape, but the present disclosure is not limited to this example. The preliminary contact portions PDC may be formed of or include at least one semiconductor material (e.g., silicon), conductive metal nitride material, or metallic material. As an example, the preliminary contact portions PDC may be formed by a chemical vapor deposition method. The formation of the preliminary contact portions PDC may include a planarization process. During the planarization process, the second etch stop layer 138 may be partially removed or may be fully removed to expose the first etch stop layer 136. In some embodiments, the planarization process may include a chemical-mechanical polishing process.

The barrier layer 166 and a conductive layer 167 may be sequentially formed on the preliminary contact portions PDC. The barrier layer 166 may be formed of or include at least one conductive metal nitride material (e.g., titanium nitride, tungsten nitride, or tantalum nitride). The conductive layer 167 may be formed of or include at least one metallic material (e.g., tungsten, titanium, or tantalum), but in some embodiments, it may be formed of or include a semiconductor material. The barrier layer 166 and the conductive layer 167 may be formed by a sputtering method or a chemical vapor deposition method.

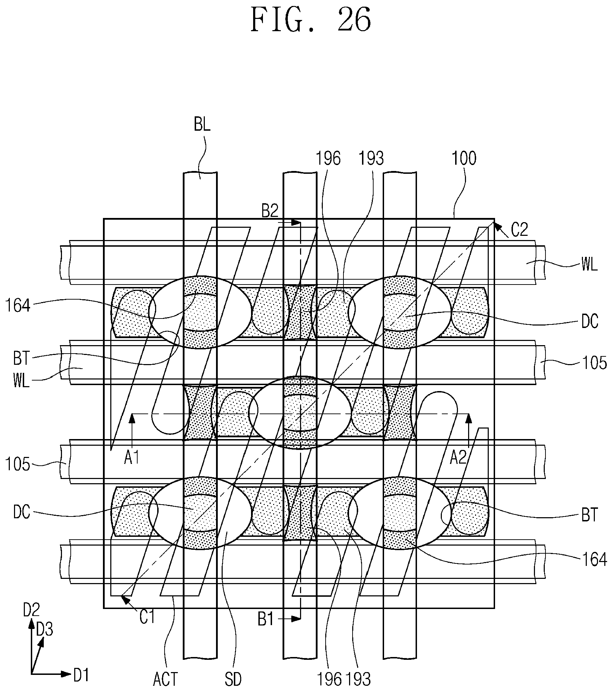

Referring to FIGS. 26 to 28, the conductive layer 167 may be patterned to form the line portions BL, which are spaced apart from each other in the first direction D1. The line portions BL may be formed by forming the bit line capping patterns 137 on the conductive layer 167 and performing an etching process on the conductive layer 167 using the bit line capping patterns 137 as a mask. During this process, the preliminary contact portions PDC, which may be provided below the line portions BL, may be patterned to form the contact portions DC. As a result, the bit line structures BS including the line portion BL and the contact portion DC may be formed.

During the formation of the contact portions DC, the preliminary sidewall insulating patterns 163, which are between the contact portions DC and the connection patterns 193, may be partially removed to form the fourth trenches BT, and in this case, the sidewall insulating patterns 164 may be formed from the preliminary sidewall insulating patterns 163. As shown in FIG. 26, a pair of the fourth trenches BT may be formed on opposite side surfaces of each contact portion DC. The fourth trenches BT may be formed to expose the first impurity regions 112a.

The spacers SD may be formed to cover the bit line capping patterns 137. The spacers SD may cover the side surfaces of the bit line structures BS. In greater detail, the spacers SD may be provided to fill the fourth trenches BT and to cover the side surfaces of the contact portions DC. The spacer SD may include the first spacer layer 121 and the second spacer layer 122.

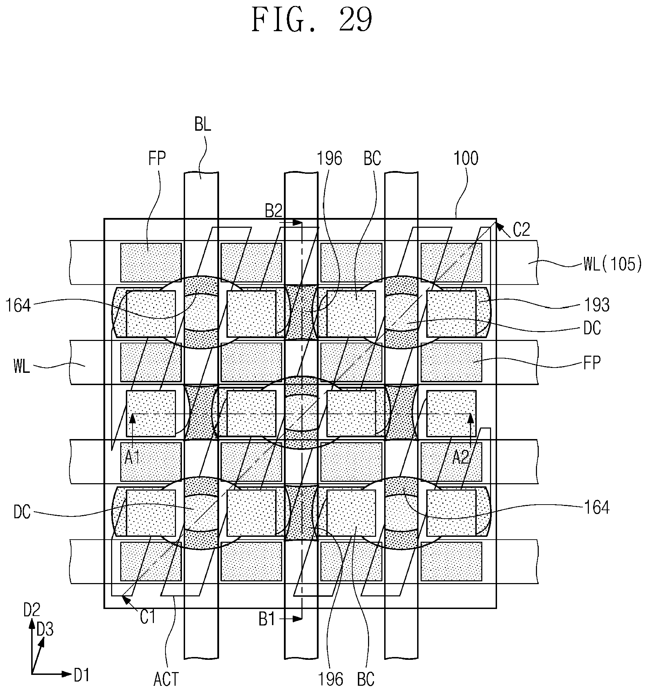

Referring to FIGS. 29 to 31, the fence patterns FP may be provided to fill regions between the bit line structures BS. The fence patterns FP may be spaced apart from each other in the first and second directions D1 and D2. The fence patterns FP may be formed of or include at least one of silicon nitride or silicon oxynitride.

The contact plugs BC may be formed in lower portions of regions defined by the bit line structures BS and the fence patterns FP. The contact plugs BC may be connected to the connection patterns 193, respectively. The contact plugs BC may be formed of or include at least one doped or undoped polysilicon and/or metallic material. The formation of the contact plugs BC may include an etch-back process.

Referring back to FIGS. 1 to 4, the landing pads LP may be formed on the contact plugs BC, respectively. The landing pads LP may be formed of or include a metal-containing material (e.g., tungsten). An ohmic layer may be provided between the contact plugs BC and the landing pads LP. The ohmic layer may be a metal silicide layer.

The gapfill structure GS may be formed to fill a region between the landing pads LP. The gapfill structure GS may be formed to fill a region between the landing pads LP, which are two-dimensionally spaced apart from each other. The gapfill structure GS may be formed of or include silicon oxide. The data storage DS may be formed on each of the landing pads LP. The data storage DS may include a capacitor. As an example, the data storage DS may include bottom electrodes, a top electrode, and a dielectric layer.

According to some embodiments of the inventive concepts, connection patterns may be formed on first impurity regions, respectively, using sacrificial patterns and a molding spacer. In some processes of dividing the connection lines, which are extended in a first direction, into connection patterns, the molding spacer may be used to form recess regions and third trenches, and thus, it may be possible to form the connection patterns without a process of forming and removing an additional mask pattern for separation in the first direction, thereby simplifying a fabrication process. In addition, since the molding spacer may be formed using side surfaces of the sacrificial patterns without a patterning process using an additional mask, it may be possible to reduce a process variation caused by a misalignment issue in a process of forming the connection patterns.

According to some embodiments of the inventive concepts, it may be possible to simplify a process of fabricating a semiconductor memory device and reduce a process variation.

While some examples of embodiments of the inventive concepts have been particularly shown and described, it will be understood by one of ordinary skill in the art that variations in form and detail may be made therein without departing from the scope of the attached claims.

## Claims

1. A semiconductor memory device, comprising:
a substrate including active regions defined by a device isolation layer, each active region including a first impurity region and a second impurity region;
word lines provided on the active regions and extending in a first direction;
bit line structures on the word lines, each of the bit line structures including a contact portion connected to a first impurity region of the active regions, and a line portion, which is provided on the contact portion and which extends in a second direction that crosses the first direction;
contact plugs between the bit line structures and connected to respective second impurity regions; and
connection patterns that connect the contact plugs to the second impurity regions of the active regions,
wherein each of the connection patterns comprises:
a first surface that faces the contact portion; and
a second surface that is opposite to the first surface, and
wherein the first surface is concave in the first direction and the second surface is convex in the first direction, when viewed in a plan view.

2. The semiconductor memory device of claim 1, wherein a curvature radius of the second surface is larger than a curvature radius of the first surface.

3. The semiconductor memory device of claim 1 or 2, further comprising a spacer that covers a side surface of the line portion, wherein the spacer extends into a region between the first surface and the contact portion.

4. The semiconductor memory device of claim 3, wherein the first surface contacts the spacer.

5. The semiconductor memory device of any one of claims 1 to 4, further comprising a separation insulating pattern in contact with the second surface, wherein a surface of the separation insulating pattern that is in contact with the second surface is concave in the first direction.

6. The semiconductor memory device of claim 5, wherein the connection patterns comprise a first connection pattern and a second connection pattern, which are connected to respective active regions and are adjacent to each other in the first direction, and wherein the first connection pattern and the second connection pattern have a mirror symmetry about the separation insulating pattern.

7. The semiconductor memory device of claim 6, wherein a first surface of the separation insulating pattern is in contact with the first connection pattern, and a second surface of the separation insulating pattern is in contact with the second connection pattern.

8. The semiconductor memory device of any one of claims 1 to 7, wherein each of the connection patterns further comprises a third surface and a fourth surface, each of which connects the first surface to the second surface, and when viewed in a plan view, the third surface and the fourth surface have a line shape.

9. The semiconductor memory device of claim 8, further comprising intermediate insulating patterns that at least partially fill spaces between the bit line structures, wherein the intermediate insulating patterns comprise a first intermediate insulating pattern that faces the third surface of the connection patterns and a second intermediate insulating pattern that faces the fourth surface of the connection patterns.

10. The semiconductor memory device of any one of claims 1 to 9, further comprising sidewall insulating patterns, which are below the line portion and are in contact with a side surface of the contact portion, wherein each contact portion is enclosed by a pair of the sidewall insulating patterns and a pair of spacers, when viewed in a plan view.

11. The semiconductor memory device of claim 10, wherein each of the sidewall insulating patterns comprises:
a first surface that is in contact with the side surface of the contact portion; and
a second surface that is opposite to the first surface,
wherein, when viewed in a plan view, the first surface of each sidewall insulating pattern is concave in the second direction and the second surface of each sidewall insulating pattern is convex in the second direction.

12. The semiconductor memory device of any one of claims 1 to 11, wherein a center width in the first direction of a first of the connection patterns at a center portion thereof is less than an edge width in the first direction of the connection pattern at an edge portion thereof.

13. A method of fabricating a semiconductor memory device in accordance with any one of claims 1 to 12, comprising:
forming a device isolation layer in a substrate to define active regions, each active region including first impurity regions and second impurity regions;
forming word lines in the substrate that extend in a first direction;
forming connection lines between the word lines that extend in the first direction;
forming sacrificial patterns on respective first impurity region;
forming a molding spacer on side surfaces of the sacrificial patterns;
patterning the connection lines, which are exposed by the molding spacer, to form preliminary connection patterns spaced apart from each other in the first direction;
removing the sacrificial patterns;
etching portions of the preliminary connection patterns below the sacrificial patterns to form connection patterns from the preliminary connection patterns;
forming bit line structures extending in a second direction that crosses the first direction, wherein the bit line structures are connected to the first impurity regions; and
forming contact plugs, which are connected to the connection patterns, between the bit line structures.
